Europäisches Patentamt

European Patent Office

Office européen des brevets

(19)

(11) Veröffentlichungsnummer: **0 183 932 B1**

(12) **EUROPÄISCHE PATENTSCHRIFT**

(45) Veröffentlichungstag der Patentschrift:
03.05.89

(51) Int. Cl.⁴: **G01P 13/02, H03M 1/00**

(21) Anmeldenummer: 85112047.7

(22) Anmeldetag: 24.09.85

(54) Impulsgeber zum Umsetzen der Bewegung eines Gebers in eine Impulsfolge.

(30) Priorität: 08.10.84 DE 3436909

(43) Veröffentlichungstag der Anmeldung:
11.06.86 Patentblatt 86/24

(45) Bekanntmachung des Hinweises auf die Patenterteilung:
03.05.89 Patentblatt 89/18

(84) Benannte Vertragsstaaten:
AT CH DE FR GB IT LI SE

(56) Entgegenhaltungen:
PATENTS ABSTRACTS OF JAPAN, Band 7,
Nr. 188 (P-217) [1333], August 1983, Seite 74 P 217; & JP
- A - 58 88 667 (HITACHI SEISAKUSHO K.K.) 26-05-1983
INTERNATIONALE ELEKTRONISCHE RUNDSCHAU,
Band 19, Nr. 7, 1965, Seiten 381-389; J. STEINHAUER:
"Ein Taktpulsgesteuerter, bidirektionaler Zähler als
Analog-Digital-Umsetzer für elektronische Waagen"
ELEKTRONIK, Band 20, Nr. 10, 1971, Seiten 337-340; J.
NEUMANN: "Bezugspunktbezogene und
schwingungsfreie Messwerte bei inkrementaler
Lagemessung"
Idem
PATENTS ABSTRACTS OF JAPAN, Band 6,
Nr. 258 (P-163) [1136], Dezember 1982, Seite 87 P 163; &
JP - A - 57 154 060 (MITSUBISHI DENKI K.K.) 22-09-1982

(73) Patentinhaber: Siemens Aktiengesellschaft Berlin und
München, Wittelsbacherplatz 2, D-8000 München 2(DE)

(72) Erfinder: Ratschmeier, Dieter, Am Rudolfshof 25,
D-8560 Lauf(DE)
Erfinder: Peter, Werner, Am Holzacker 114,
D-8540 Schwabach-Wolkersdorf(DE)

## Beschreibung

Die Erfindung betrifft einen Impulsgeber zum Umsetzen der Bewegung eines Gebers in eine von der Bewegungsrichtung abhängige Impulsfolge nach dem Oberbegriff des Patentanspruchs 1.

Derartige Impulsgeber werden meist zur Erfassung von Drehbewegungen eingesetzt. Beispielsweise können Ferraris-Zähler mit solchen Impulsgebern ausgerüstet werden, die dann für jede volle Umdrehung oder für ganzzahlige Teile einer Umdrehung der Läuferscheibe einen Impuls abgeben. Jeder Impuls entspricht dann einer bestimmten, durch die Zählerkonstanten festgelegten Menge der gemessenen Energie. Durch Aufzählen der abgegebenen Impulse über einen vorgegebenen Zeitabschnitt kann der Energieverbrauch in diesem Zeitabschnitt ermittelt werden. Beim Rückdrehen der Zählerscheibe durch Änderung der Energieflußrichtung oder durch Pendeln der Läuferscheibe um die Ruhelage können zusätzliche Impulse abgegeben werden, die der zu messenden Energie nicht entsprechen und daher zu einer falschen Anzeige des Energieverbrauchs führen.

Bei Zählern, die nur eine Energierichtung messen, kann zwar das Rückdrehen der Läuferscheibe durch eine mechanische Rücklaufsperre verhindert werden. Es ist aber dennoch ein Pendeln innerhalb des Fangbereichs der Rücklaufsperre möglich, das zu Fehlmessungen führen kann.

Bei Zählern, die nur eine Energierichtung messen, kann zwar das Rückdrehen der Läuferscheibe durch eine mechanische Rücklaufsperre verhindert werden. Es ist aber dennoch ein Pendeln innerhalb des Fangbereichs der Rücklaufsperre möglich, das zu Fehlmessungen führen kann.

Bei handelsüblichen Abtasteinrichtungen für die Läuferscheibe von Ferraris-Zählern, die ein analoges, sinusförmiges Ausgangssignal liefern, wird die Abgabe von Fehlimpulsen in einem bestimmten Pendelbereich durch eine entsprechend große Schalthysterese vermieden. Diese Schalthysterese wird mit einem nachgeschalteten Schmitt-Trigger erzeugt. Derartige Abtasteinrichtungen sind jedoch nur mit relativ hohem Aufwand realisierbar. Zudem beeinflussen die Umgebungstemperatur und die Toleranz der Bauteile das Schaltverhalten wesentlich. In vielen Fällen ist eine entsprechende Justage zur Einstellung der richtigen Arbeitsweise notwendig. Die in Zusammenhang mit Abtasteinrichtungen für Ferraris-Zähler dargestellten Probleme treten in analoger Weise auch bei anderen Impulsgeberschaltungen auf.

Aus "Patent Abstracts of Japan", Band 7, Nr. 188 (P-217), (1333), August 1983, Seite 74 P 217 sowie JP-A 5 888 667 ist ein Impulsgeber der im Oberbegriff des Anspruchs 1 genannten Art bekannt. Der Nachteil dieser Schaltungsanordnung besteht jedoch darin, daß für die drehrichtungsabhängigen Ausgangsimpulse eine zusätzliche Auswerteschaltung in Form eines Mikrocomputers erforderlich ist.

Aus der Zeitschrift "Elektronik", Band 20, Nr. 10, 1971, Seiten 337–340 ist eine elektronische Zweirichtungs-Impulszählschaltung bekannt, bei der durch Pendelbewegungen entstehende abwechselnd auftretende Vorwärts- und Rückwärts-Zählimpulse durch eine Logikschaltung unterdrückt werden. Diese Logikschaltung enthält vier Flip-Flops, denen die zwei gegeneinander phasenverschobenen, vom Drehgeber stammenden Impulsfolgen bzw. die dazu inversen Impulsfolgen zugeführt werden. Diese Schaltungsanordnung ist relativ aufwendig.

Der Erfindung liegt die Aufgabe zugrunde, einen Impulsgeber der eingangs genannten Art so auszuführen, daß Fehlimpulse bei Wechsel der Bewegungsrichtung, auch bei Pendelbewegungen, innerhalb eines gewissen Bereiches mit geringem Aufwand vermieden werden.

Diese Aufgabe wird durch die im Patentanspruch 1 angegebene Erfindung gelöst.

Damit wird erreicht, daß beim Wechsel der Bewegungsrichtung oder beim Pendeln bis zu einer halben Impulsteilung kein Fehlimpuls abgegeben wird. Für die Realisierung sind lediglich ein einfacher digitaler Impulsgeber und zwei Flip-Flops nötig.

Wenn auch in der zweiten Bewegungsrichtung die Impulse gemessen werden sollen, so kann gemäß einer Weiterbildung der Erfindung gemäß Patentanspruch 2 eine zusätzliche Auswerteschaltung vorgesehen werden.

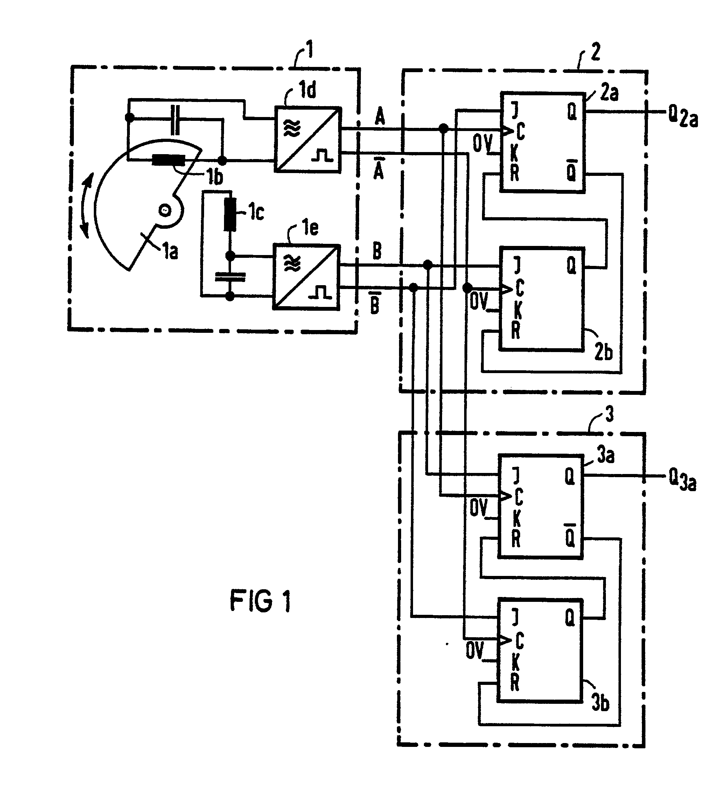

Ein Ausführungsbeispiel der Erfindung wird nachfolgend anhand der Figuren 1 bis 21 näher erläutert.

Fig. 1 zeigt ein Prinzipschaltbild der Anordnung. Ein Impulsgeber 1 enthält eine Geberscheibe 1a, die eine Drehbewegung ausführt und im Beispiel einen Flügel aufweist. Über der Scheibe 1a sind zwei gegeneinander versetzte Spulen 1b und 1c als Sensoren angeordnet, die von je einer Wandlerschaltung 1d bzw. 1e mit Wechselspannung beaufschlagt werden. Die Induktivität der Sensoren 1b und 1c hängt davon ab, ob sie sich gerade im Bereich eines Flügels der Geberscheibe 1a befinden. Dies wird von den Wandlerschaltungen 1d und 1e ausgewertet, die immer dann am Ausgang A bzw. B ein "1"-Signal abgeben, wenn die zugeordnete Sensorspule 1b bzw. 1c über einem Flügel der Geberscheibe 1a liegt. Die Wandlerschaltungen 1d und 1e weisen ferner Ausgänge $\overline{A}$ bzw. $\overline{B}$ auf, die das jeweils invertierte Signal der Ausgänge A bzw. B abgeben. Ein entsprechender Impulsgeber könnte selbstverständlich nicht nur für Drehbewegungen, sondern auch für lineare Bewegungen aufgebaut werden, wenn man die rotierende Geberscheibe durch eine gerade Anordnung mit entsprechenden Zähnen ersetzt.

Mit einer Auswerteschaltung 2, die zwei JK-Flip-Flops 2a und 2b enthält, sollen nunmehr nur die Impulse erfaßt werden, die bei einer Drehung im Uhrzeigersinn auftreten. Dazu ist der Ausgang A der Wandlerschaltung 1d mit dem Takteingang des ersten Flip-Flops 2a und der Ausgang $\overline{A}$ mit dem Takteingang des zweiten JK-Flip-Flops 2b verbunden. Der Ausgang B der Wandlerschaltung 1e ist mit dem J-Eingang des zweiten JK-Flip-Flops 2b und der Ausgang $\overline{B}$ mit dem J-Eingang des ersten JK-Flip-Flops 2a verbunden. Ferner ist der nichtinvertierende Ausgang Q des zweiten JK-Flip-Flops 2b mit dem taktunabhängigen Rücksetzeingang R des ersten JK-Flip-Flops 2a und der invertierende Aus-

gang $\bar{Q}$ des ersten JK-Flip-Flops 2a mit dem taktunabhängigen Rücksetzeingang R des zweiten Flip-Flops 2b verbunden. Am nichtinvertierenden Ausgang des ersten JK-Flip-Flops 2a steht die gewünschte Impulsfolge für die Drehung in Vorwärtsrichtung an.

Mit einer zweiten Auswerteschaltung 3, die ebenfalls zwei JK-Flip-Flops 3a und 3b enthält, können auch die Impulse bei Rückwärtsdrehung erfaßt werden. Dazu ist der Ausgang A der Wandlerschaltung 1d mit dem Takteingang eines dritten JK-Flip-Flops 3a und der Ausgang $\bar{A}$ mit dem Takteingang eines vierten JK-Flip-Flops 3b verbunden. Der Ausgang B der Wandlerschaltung 1e ist mit dem J-Eingang des dritten JK-Flip-Flops 3a und der Ausgang $\bar{B}$ mit dem J-Eingang des vierten JK-Flip-Flops 3b verbunden. Der nichtinvertierende Ausgang Q des vierten JK-Flip-Flops 3b ist mit dem taktunabhängigen Rücksetzeingang R des dritten JK-Flip-Flops 3a und der invertierende Ausgang $\bar{Q}$ des dritten JK-Flip-Flops 3a mit dem taktunabhängigen Rücksetzeingang des vierten JK-Flip-Flops 3b verbunden. An den K-Eingängen der beiden JK-Flip-Flops 2a und 2b steht jeweils ein "0"-Signal an. Am nichtinvertierenden Ausgang Q des dritten JK-Flip-Flops 3a stehen die gewünschten Impulse bei Rückwärtsdrehung der Geberscheibe an.

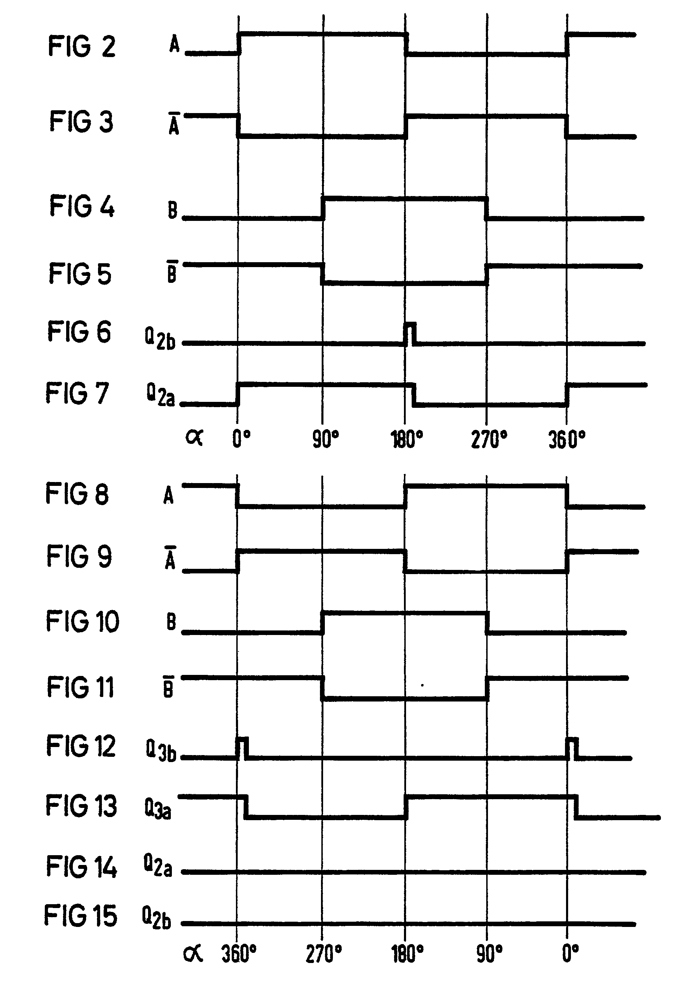

Die Funktion der dargestellten Schaltung wird nachfolgend anhand der Diagramme nach den Figuren 2 bis 7 für die Vorwärtsdrehung der Geberscheibe 1a erläutert. Dabei wird von einer Impulsteilung von 360°, d.h. einem Impuls pro Umdrehung der Geberscheibe ausgegangen. Die entsprechende Winkelstellung α der Geberscheibe 1a ist in den Diagrammen mit angegeben.

Fig. 2 zeigt das Ausgangssignal A der Wandlerschaltung 1d,

Fig. 3 das dazu invertierte Ausgangssignal $\bar{A}$,

Fig. 4 zeigt das Ausgangssignal B der Wandlerschaltung 1e und

Fig. 5 das dazu invertierte Ausgangssignal $\bar{B}$.

Man erkennt, daß die Impulse des Signals B den Impulsen des Signals A um 90° nacheilen, was von der Auswerteschaltung 2 als Kriterium für die Vorwärtsdrehung ausgewertet wird.

Fig. 6 zeigt das Ausgangssignal $Q_{2b}$ am Ausgang Q des zweiten JK-Flip-Flops 2b,

Fig. 7 das Ausgangssignal $Q_{2a}$ am Ausgang Q des ersten JK-Flip-Flops 2a.

Mit jeder steigenden Flanke des Signals A wird das JK-Flip-Flop 2a gesetzt, da am J-Eingang mit dem Signal $\bar{B}$ ein "1"-Signal ansteht. Damit geht also das Ausgangssignal $Q_{2a}$ auf "1". Mit der steigenden Flanke des Signals $\bar{A}$ wird das zweite JK-Flip-Flop 2b gesetzt, da an seinem J-Eingang mit dem Signal B ein "1"-Signal ansteht. Damit wird das Ausgangssignal $Q_{2b}$ "1", so daß über den Rücksetzeingang R das erste JK-Flip-Flop 2a zurückgesetzt wird, d.h. das Ausgangssignal $Q_{2a}$ auf "0" wechselt. Da gleichzeitig das nichtdargestellte Ausgangssignal am invertierenden Ausgang $\bar{Q}$ des ersten Flip-Flops 2a auf "1" wechselt, wird das zweite JK-Flip-Flop 2b über seinen Rücksetzeingang R wieder zurückgesetzt. Damit gibt also die Auswerteschaltung 2 für jeden Impuls des Impulsgebers 1 wiederum einen Impuls ab, sofern sich die Geberscheibe 1a in Vorwärtsrichtung dreht. Die vom Sensor gegebene Winkelauflösung bleibt erhalten.

Die Auswerteschaltung 3 soll nur dann Impulse abgeben, wenn eine Drehung in Rückwärtsrichtung erfolgt. Die Funktion dieser Schaltung ist in den Figuren 8 bis 15 dargestellt. Dabei zeigt

Fig. 8 wieder das Ausgangssignal A der Wandlerschaltung 1d,

Fig. 9 das invertierte Ausgangssignal $\bar{A}$,

Fig. 10 das Ausgangssignal B der Wandlerschaltung 1e und

Fig. 11 das invertierte Ausgangssignal $\bar{B}$.

Dabei erkennt man, daß bei Rückwärtsdrehung die Impulse des Signals B den Impulsen des Signals A um 90° nacheilen, was von der Auswerteschaltung 3 als Kriterium für die Rückwärtsdrehung verwendet wird.

Fig. 12 zeigt das Ausgangssignal $Q_{3b}$ des vierten JK-Flip-Flops 3b und

Fig. 13 das Ausgangssignal $Q_{3a}$ des dritten JK-Flip-Flops 3a.

Das dritte JK-Flip-Flop 3a wird mit jeder positiven Flanke des Signals A gesetzt, da an seinem J-Eingang mit dem Signal B gleichzeitig ein "1"-Signal ansteht. Mit jeder steigenden Flanke des Signals $\bar{A}$, d.h. jeder fallenden Flanke des Signals A, wird das vierte JK-Flip-Flop 3b gesetzt, da an seinem J-Eingang mit dem Signal $\bar{B}$ gleichzeitig ein "1"-Signal ansteht. Mit dem dadurch am Ausgang Q des JK-Flip-Flops 3b anstehenden "1"-Signal wird über den Rücksetzeingang R das dritte JK-Flip-Flop 3a zurückgesetzt. Über das damit am Ausgang $\bar{Q}$ des dritten JK-Flip-Flops 3a anstehende "1"-Signal wird wiederum das vierte JK-Flip-Flop 3b zurückgesetzt. Die Auswerteschaltung 3 gibt also für jeden Impuls der Geberschaltung 1 einen Ausgangsimpuls ab, sofern sich die Geberscheibe 1a in Rückwärtsrichtung dreht.

Die Figuren 14 und 15 zeigen ferner die Ausgangssignale $Q_{2a}$ und $Q_{2b}$ an den Q-Ausgängen des ersten und zweiten JK-Flip-Flops 2a und 2b. Dabei sieht man, daß bei Rückwärtsdrehung keines dieser JK-Flip-Flops gesetzt wird. Ein Setzen des ersten JK-Flip-Flops 2a ist nämlich nur bei positiven Flanken des Signals A möglich. Dabei ist jedoch das an seinem J-Eingang anstehende Signal $\bar{B}$ stets "0, so daß kein Setzen erfolgt. In gleicher Weise ist auch das am J-Eingang des zweiten JK-Flip-Flops 2b anstehende Signal B stets "0", wenn das an seinem Takteingang anstehende Signal $\bar{A}$ eine steigende Flanke aufweist. Der beschriebene Impulsgeber gibt also bei Vorwärts- und Rückwärtsdrehung Impulse an jeweils getrennten Ausgängen ab.

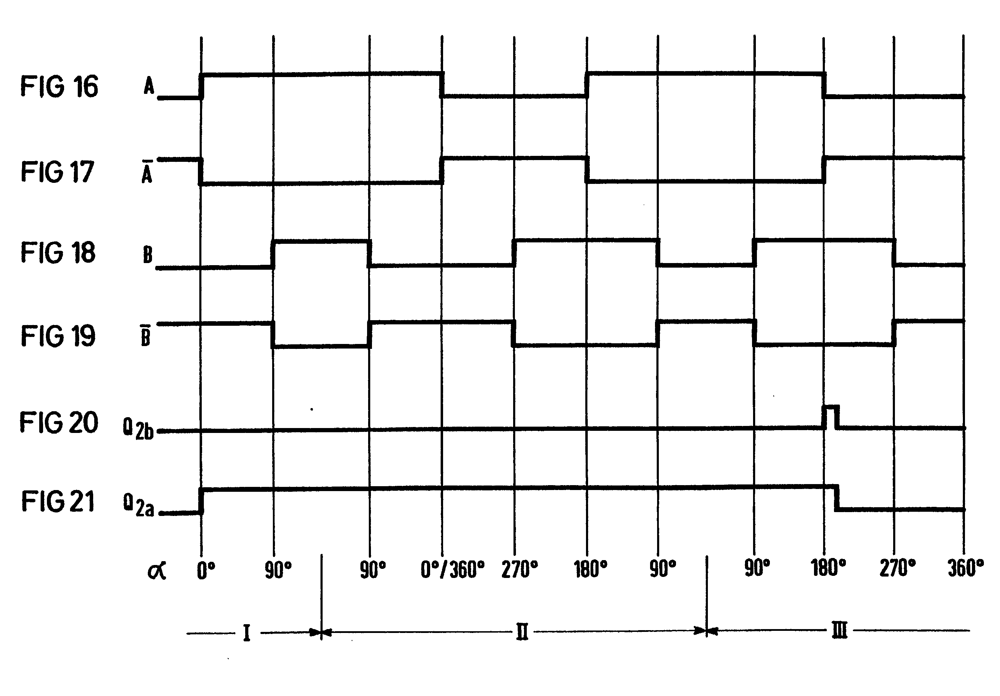

Wie bereits eingangs erwähnt, ist es sehr wichtig, daß der Impulsgeber bei einer Pendelbewegung der Geberscheibe keine Impulse abgibt. Unter Pendelbewegungen werden dabei Vor- und Rückdrehungen der Geberscheibe verstanden, die in einem Winkel bis zu einer halben Impulsteilung liegen. Anhand der Figuren 16 bis 21 wird im folgenden gezeigt, daß die dargestellte Schaltung diese Anforderung erfüllt.

Fig. 16 zeigt wieder das Ausgangssignal A der Geberschaltung 1d,

Fig. 17 das invertierte Ausgangssignal $\bar{A}$,

Fig. 18 das Ausgangssignal B der Wandlerschaltung 1e und

Fig. 19 das dazu invertierte Ausgangssignal $\bar{B}$.

In einem mit I bezeichneten Bereich soll eine Vorwärtsdrehung der Geberscheibe 1a, in einem Bereich II eine Rückwärtsdrehung und in einem Bereich III wieder eine Vorwärtsdrehung mit den angegebenen Winkelstellungen α erfolgen.

Im Bereich I ist der Impuls des Signals B gegenüber dem Impuls des Signals A nacheilend, im Bereich II voreilend und im Bereich III schließlich wieder nacheilend.

Fig. 20 zeigt das Ausgangssignal $Q_{2b}$ am Ausgang Q des zweiten JK-Flip-Flops 2b und

Fig. 21 das Ausgangssignal $Q_{2a}$ am Ausgang Q des ersten JK-Flip-Flops 2a.

Dabei erkennt man, daß das erste JK-Flip-Flop 2a mit der ersten Flanke des Signals A gesetzt wird, da gleichzeitig das Ausgangssignal $\bar{B}$"1" ist. Der Zustand des ersten Flip-Flops 2a bleibt unverändert, bis das zweite JK-Flip-Flop 2b gesetzt wird. Dies ist erst nach einer erneuten Vorwärtsdrehung im Bereich III der Fall, da hierbei eine positive Signalflanke des Signals $\bar{A}$ am Takteingang des zweiten JK-Flip-Flops 2b mit einem "1"-Signal des Signals B am J-Eingang des zweiten JK-Flip-Flops zusammentrifft. Damit wird das erste JK-Flip-Flop 2a über seinen Rücksetzeingang R und anschließend auch das zweite JK-Flip-Flop 2b zurückgesetzt. Damit ist also sichergestellt, daß das erste JK-Flip-Flop nur dann einen vollständigen Impulszyklus abgibt, wenn der Impulsgeber die Winkelstellung von 0 bis 360° in Vorwärtsrichtung durchlaufen hat. Dies gilt in äquivalenter Weise auch für das auf Rückwärtsdrehung ansprechende dritte JK-Flip-Flop 3a.

**Patentansprüche**

1. Impulsgeber zum Umsetzen der Bewegung eines Gebers in eine von der Bewegungsrichtung abhängige Impulsfolge, mit einem Sensor (1), der zwei gegeneinander phasenverschobene Impulsfolgen abgibt, wobei die Richtung der Phasenverschiebung von der Bewegungsrichtung abhängt und die erste Impulsfolge (A) dem Takteingang eines ersten JK-Flip-Flops (2a) und invertiert dem Takteingang eines zweiten JK-Flip-Flops (2b) und die zweite Impulsfolge (B) invertiert dem J-Eingang des ersten JK-Flip-Flops (2a) zugeführt ist, dadurch gekennzeichnet, daß die zweite Impulsfolge (B), in nicht invertierter Form, dem J-Eingang des zweiten JK-Flip-Flops (2b) zugeführt ist und daß der taktunabhängige Rücksetzeingang des ersten JK-Flip-Flops (2a) mit dem nichtinvertierenden Ausgang des zweiten JK-Flip-Flops (2b) und der taktunabhängige Rücksetzeingang des zweiten JK-Flip-Flops (2b) mit dem invertierenden Ausgang des ersten JK-Flip-Flops (2a) verbunden ist, wobei an einem Ausgang des ersten JK-Flip-Flops (2a) die gewünschte Impulsfolge für eine erste Bewegungsrichtung abgegriffen wird.

2. Impulsgeber nach Anspruch 1, dadurch gekennzeichnet, daß die erste Impulsfolge (A) zusätzlich dem Takteingang eines dritten JK-Flip-Flops (3a) und invertiert dem Takteingang eines vierten JK-Flip-Flops (3b) zugeführt ist, daß die zweite Impulsfolge (B) zusätzlich dem J-Eingang des dritten JK-Flip-Flops (3a) und invertiert dem J-Eingang des vierten JK-Flip-Flops (3b) zugeführt ist, daß der taktunabhängige Rücksetzeingang des dritten JK-Flip-Flops (3a) mit dem nichtinvertierenden Ausgang des vierten JK-Flip-Flops (3b) und der taktunabhängige Rücksetzeingang des vierten JK-Flip-Flops (3b) mit dem invertierenden Ausgang des dritten JK-Flips-Flops (3a) verbunden ist, wobei an einem Ausgang des dritten JK-Flip-Flops (3a) die gewünschte Impulsfolge für die zweite Bewegungsrichtung abgegriffen wird.

**Claims**

1. Pulse transmitter for converting the movement of a transmitter into a series of pulses dependent upon the direction of movement, having a sensor (1) which emits two series of pulses phase-shifted in respect of each other, the direction of the phase shift depending upon the direction of movement and the first series of pulses (A) being supplied to the clock input of a first JK flip-flop (2a) and inverted to the clock input of a second JK flip-flop (2b), and the second series of pulses (B) being supplied inverted to the J input of the first JK flip-flop (2a), characterised in that the second series of pulses (B), in non-inverted form, is supplied to the J input of the second JK flip-flop (2b) and in that the clock-independent reset input of the first JK flip-flop (2a) is connected with the non-inverting output of the second JK flip-flop (2b), and the clock-independent reset input of the second JK flip-flop (2b) is connected with the inverting output of the first JK flip-flop (2a), in which case the desired series of pulses for a first direction of movement is picked off at an output of the first JK flip-flop (2a).

2. Pulse transmitter according to claim 1, characterised in that the first series of pulses (A) is supplied in addition to the clock input of a third JK flip-flop (3a) and inverted to the clock input of a fourth JK flip-flop (3b), in that the second series of pulses (B) is supplied in addition to the J input of the third JK flip-flop (3a) and inverted to the J input of the fourth JK flip-flop (3b), in that the clock-independent reset input of the third JK flip-flop (3a) is connected with the non-inverting output of the fourth JK flip-flop (3b), and the clock-independent reset input of the fourth JK flip-flop (3b) is connected with the inverting output of the third JK flip-flop (3a), in which case the desired series of pulses for the second direction of movement is picked off at an output of the third JK flip-flop (3a).

**Revendications**

1. Générateur d'impulsions servant à convertir le déplacement d'un transmetteur en une suite d'impulsions dépendant de la direction de déplacement, comportant un capteur (1), qui délivre deux suites d'impulsions déphasées l'une par rapport à l'autre, et dans lequel la direction de déphasage dépend du déplacement et la première suite d'impulsions (A) est envoyée à l'entrée de cadence d'une première bascule bistable de type JK (2a) et, en étant inversée, à l'entrée de cadence d'une seconde bascule bistable de type JK (2b), et la seconde suite d'impulsions (B) est envoyée, en étant inversée, à l'entrée J de la première bascule bistable de type JK (2a), caractérisé par le fait que la seconde suite d'impulsions (B) est envoyée, sous forme non inversée, à l'entrée J de la seconde bascule bistable de type JK (2b), que l'entrée de remise à l'état initial, qui est indépendante de la cadence, de la première bascule bistable de type JK (2a) est reliée à la sortie non inverseuse de la seconde bascule bistable de type JK (2b) et que l'entrée de remise à l'état initial, qui est indépendante de la cadence, de la seconde bascule bistable de type JK (2b) est reliée à la sortie inverseuse de la première bascule bistable de type JK (2a), la suite désirée d'impulsions pour une première direction de déplacement étant prélevée sur une sortie de la première bascule bistable de type JK (2a).

2. Générateur d'impulsions suivant la revendication 1, caractérisé par le fait que la première suite d'impulsions (A) est envoyée en outre à l'entrée de cadence d'une troisième bascule bistable de type JK (3a) et, en étant inversée, à l'entrée de cadence d'une quatrième bascule bistable de type JK (3b), que la seconde suite d'impulsions (B) est envoyée en outre à l'entrée J de la troisième bascule bistable de type JK (3a) et, en étant inversée, à l'entrée J de la quatrième bascule bistable de type JK (3b), et que l'entrée de remise à l'état initial, qui est indépendante de la cadence, de la troisième bascule bistable de type JK (3a) est reliée à la sortie non inverseuse de la quatrième bascule bistable de type JK (3b) et que l'entrée de remise à l'état initial, qui est indépendante de la cadence, de la quatrième bascule bistable de type JK (3b) est reliée à la sortie inverseuse de la troisième bascule bistable de type JK (3a), la suite désirée d'impulsions pour la seconde direction de déplacement étant prélevée sur une sortie de la troisième bascule bistable de type JK (3a).

FIG 1

FIG 2   A

FIG 3   $\overline{A}$

FIG 4   B

FIG 5   $\overline{B}$

FIG 6   $Q_{2b}$

FIG 7   $Q_{2a}$

$\alpha$   0°   90°   180°   270°   360°

FIG 8   A

FIG 9   $\overline{A}$

FIG 10   B

FIG 11   $\overline{B}$

FIG 12   $Q_{3b}$

FIG 13   $Q_{3a}$

FIG 14   $Q_{2a}$

FIG 15   $Q_{2b}$

$\alpha$   360°   270°   180°   90°   0°

FIG 16  A

FIG 17  $\bar{A}$

FIG 18  B

FIG 19  $\bar{B}$

FIG 20  $Q_{2b}$

FIG 21  $Q_{2a}$

$\alpha$  0°  90°  90°  0°/360°  270°  180°  90°  90°  180°  270°  360°

I  II  III

EP 0 183 932 B1